# DEMANDE DE BREVET EUROPEEN

(11) **EP 1 513 310 A1**
(43) Date de publication de la demande: **09.03.2005**
(21) Numéro de dépôt: 04292080.1
(22) Date de dépôt: 24.08.2004
(51) Int. Cl.: H04L 27/00, H04L 27/38, H03L 7/113

(54) **Procédé et dispositif de correction du décalage fréquentiel de la fréquence porteuse d'un signal modulé avec une modulation monoporteuse continue en quadrature.**

(30) Priorité: 02.09.2003 FR 0310388
(71) Demandeur: STMicroelectronics S.A., 92120 Montrouge (FR)
(72) Inventeur: Paille, Bruno, 38960 Saint-Aupre (FR)
(74) Mandataire: Zapalowicz, Francis

(57) **Abrégé**

On effectue une première estimation dudit décalage avec un estimateur de fréquence EST de façon à obtenir une première valeur d'estimation puis on affine l'estimation dudit décalage fréquentiel et on corrige en conséquence la fréquence porteuse, avec une boucle à verrouillage de phase PLL initialisée avec ladite première valeur d'estimation et dont la plage fréquentielle d'accrochage est inférieure à la plage fréquentielle d'accrochage de l'estimateur de fréquence.

## Description

L'invention concerne le décodage de canaux de transmission radiofréquence véhiculant des informations numériques codées.

Plus précisément, l'invention concerne l'acquisition de la fréquence porteuse d'un signal modulé avec une modulation continue en quadrature monoporteuse, par exemple une modulation d'amplitude en quadrature dite « modulation QAM » en langue anglaise.

Des solutions actuellement utilisées pour effectuer l'acquisition et le suivi de la fréquence porteuse sont basées sur des boucles à verrouillage de phase.

Plus précisément, une première catégorie de solution utilise une boucle à verrouillage de phase ayant une large plage d'accrochage fréquentielle pour l'acquisition de la fréquence porteuse puis, une plage d'accrochage fréquentielle plus faible lors du suivi de la fréquence porteuse. Cependant, une telle solution présente l'inconvénient que l'acquisition peut échouer dans le cas d'un signal d'entrée de mauvaise qualité.

Une seconde catégorie de solution utilise une boucle à verrouillage de phase ayant une plage d'accrochage fréquentielle étroite de façon à pouvoir faire l'acquisition d'un signal de mauvaise qualité et utilise en parallèle un algorithme de balayage fréquentiel afin de faire l'acquisition d'un signal présentant un fort décalage fréquentiel de la fréquence porteuse. Cependant, cette deuxième solution présente l'inconvénient de nécessiter un temps important de verrouillage.

L'invention vise à remédier à ces inconvénients et propose une solution radicalement différente de celles existant jusqu'à maintenant.

Un but de l'invention est de pouvoir estimer et corriger de forts décalages fréquentiels, par exemple de l'ordre de quelques centaines de KHz, même avec un signal d'entrée de mauvaise qualité, par exemple présentant un rapport signal/bruit de l'ordre de 20 dB pour une modulation 64-QAM, et ce pendant un temps court, par exemple de l'ordre de la centaine de millisecondes.

L'invention propose donc un procédé de traitement du décalage fréquentiel de la fréquence porteuse d'un signal modulé avec une modulation monoporteuse continue en quadrature, dans lequel on effectue une première estimation dudit décalage avec un estimateur de fréquence de façon à obtenir une première valeur d'estimation, puis on affine l'estimation dudit décalage fréquentiel et on corrige en conséquence la fréquence porteuse avec une boucle à verrouillage de phase initialisée avec ladite première valeur d'estimation et dont la plage fréquentielle d'accrochage est inférieure à la plage fréquentielle d'accrochage de l'estimateur de fréquence.

En d'autres termes, selon l'invention, l'acquisition et le suivi de la fréquence porteuse est basé sur l'utilisation d'un estimateur de fréquence en combinaison avec une boucle à verrouillage de phase. Lors de l'acquisition, l'estimateur de fréquence réalise une estimation du décalage fréquentiel, de manière non précise, tandis que la boucle de verrouillage de phase est désactivée. Puis, une fois le résultat de cette première estimation obtenue, celui-ci est utilisé pour initialiser la boucle de verrouillage de phase présentant une plage d'accrochage fréquentielle étroite.

Ainsi, la boucle à verrouillage de phase va affiner le résultat de l'estimation délivré par l'estimateur de fréquence et fournir une estimation avec une meilleure précision.

Selon un mode de mise en oeuvre de l'invention, l'oscillateur de la boucle à verrouillage de phase est commandé par la sortie du filtre de boucle augmentée par ladite première valeur d'estimation.

Le signal reçu par l'estimateur de fréquence comporte des échantillons appartenant à une constellation de points. Cette constellation peut être carrée (cas par exemple des modulations dites 16QAM, 64QAM, 256QAM ou 1024QAM) ou non carrée (cas par exemple des modulations dites 32QAM, 128QAM, ou 512QAM). Pour les constellations dites carrées, et selon un mode de mise en oeuvre de l'invention, permettant de réaliser l'estimation de fréquence de façon relativement simple et rapide même avec une modulation du type QAM présentant un nombre d'états élevés, on effectue ladite première estimation en utilisant uniquement des échantillons reçus situés dans les zones de coin du carré.

Les constellations dite non-carrées possèdent néanmoins une zone interne de points carrée. Pour ces constellations dites non-carrées, et selon un mode de mise en oeuvre de l'invention, permettant de réaliser l'estimation de fréquence de façon relativement simple et rapide même avec une modulation du type QAM présentant un nombre d'états élevés, on effectue ladite première estimation en utilisant uniquement des échantillons reçus situés dans les zones de coin du carré interne.

On effectue avantageusement ladite première estimation sur un nombre prédéterminé d'échantillons du signal reçu par l'estimateur de fréquence, par exemple sur une centaine de milliers d'échantillons.

Selon un mode de mise en oeuvre de l'invention, après activation de la boucle à verrouillage de phase, on poursuit l'estimation dudit décalage fréquentiel avec l'estimateur de fréquence, et on utilise cette nouvelle estimation pour contrôler l'évolution de la valeur de la fréquence porteuse.

On va ainsi par exemple vérifier que les nouvelles valeurs estimées pour le décalage fréquentiel ne varient pas trop. Plus précisément, on pourra comparer la variance de ces estimations à un seuil prédéterminé.

L'invention propose également un dispositif de traitement du décalage fréquentiel de la fréquence porteuse d'un signal incident modulé avec une modulation monoporteuse continue en quadrature.

Selon une caractéristique générale de l'invention, le dispositif comprend
- une entrée de signal,
- un estimateur de fréquence connecté à ladite entrée apte à délivrer une première valeur d'estimation dudit décalage fréquentiel,
- une boucle à verrouillage de phase connectée à ladite entrée et dont la plage fréquentielle d'accrochage est inférieure à la plage fréquentielle d'accrochage de l'estimateur de fréquence,
- des moyens de commande aptes à n'activer la boucle à verrouillage de phase qu'à la délivrance de ladite première valeur d'estimation, et
- des moyens d'initialisation aptes à initialiser la boucle à verrouillage de phase avec ladite première valeur d'estimation.

Selon un mode de réalisation de l'invention, les moyens d'initialisation comportent un moyen de mémoire, tel qu'un registre, apte à stocker ladite première valeur d'estimation et un additionneur possédant une première entrée connectée à la sortie du filtre de boucle, une deuxième entrée connectée audit moyen de mémoire et une sortie connectée à l'entrée de commande de l'oscillateur de boucle.

Le signal reçu par l'estimateur de fréquence comporte des échantillons appartenant à une constellation de points dont certains appartiennent à un carré (ce carré est externe pour les modulations carrées et interne pour les modulations non-carrées). Et, selon un mode de réalisation de l'invention, ledit estimateur de fréquence effectue ladite première estimation en utilisant uniquement des échantillons reçus situés dans les zones de coins du carré.

Selon un mode de réalisation de l'invention, les moyens de commande déconnectent l'estimateur de fréquence de la boucle à verrouillage de phase après l'activation de la boucle à verrouillage de phase, et l'estimateur poursuit alors l'estimation dudit décalage fréquentiel. Le dispositif comporte en outre des moyens de contrôle connectés à la sortie de l'estimateur et aptes à utiliser toute nouvelle estimation pour contrôler l'évolution de la valeur de la fréquence porteuse.

Le dispositif selon l'invention est avantageusement réalisé de façon intégrée.

L'invention propose également un récepteur de signaux modulés avec une modulation monoporteuse continue en quadrature, comportant un dispositif de traitement tel que défini ci-avant.

D'autres avantages et caractéristiques de l'invention apparaîtront à l'examen de la description détaillée de modes de réalisation et de mise en oeuvre, nullement limitatifs, et des dessins annexés, sur lesquels :
- la figure 1 illustre schématiquement un récepteur de signaux selon l'invention, incorporant un dispositif de traitement selon l'invention ;
- la figure 2 illustre plus en détail, mais toujours schématiquement, un mode de réalisation d'un dispositif de traitement selon l'invention ;
- la figure 3 représente, sur un exemple de modulation carrée, des zones de coins utilisées dans l'estimation du décalage fréquentiel de la fréquence porteuse ;
- la figure 4 représente, sur un exemple de modulation non-carrée, des zones de coins utilisées dans l'estimation du décalage fréquentiel de la fréquence porteuse ; et
- la figure 5 est un organigramme schématique d'un mode de mise en oeuvre du procédé selon l'invention.

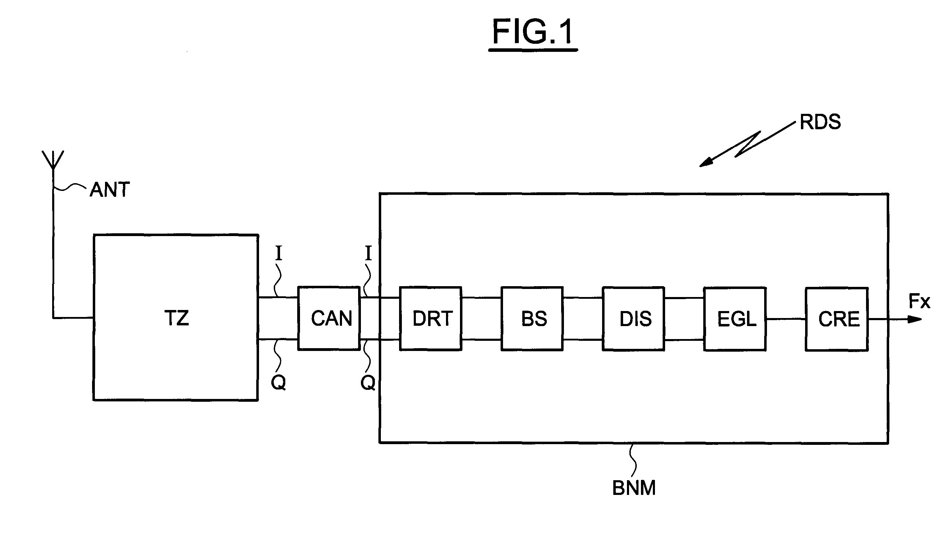

Sur la figure 1, la référence RDS désigne un récepteur de signaux selon l'invention. Les signaux incidents reçus au niveau de l'antenne ANT du récepteur sont des signaux modulés avec une modulation monoporteuse continue en quadrature, par exemple une modulation d'amplitude en quadrature à N états, dite (« modulation N-QAM » en langue anglaise).

Le récepteur RDS comporte en tête un tuner ou synthonisateur relié à l'antenne ANT. Le tuner TZ permet de transposer le signal reçu par l'antenne en un signal à une fréquence prédéterminée, qui peut être la fréquence nulle (le signal est alors en bande de base) si le tuner présente une architecture du type à fréquence intermédiaire nulle (ZIF) ou bien à une fréquence intermédiaire non nulle, par exemple 36 ou 44 MHz.

Le signal issu du tuner TZ et qui a été transposé sur deux voies en quadrature de phase I et Q si le tuner est à fréquence intermédiaire nulle ou sur une seule voie si le signal est centré sur une fréquence non nulle, est ensuite échantillonné dans un étage de conversion analogique/numérique CAN.

A la sortie de cet étage de conversion analogique/numérique CAN, est connecté un bloc numérique de traitement BNM qui comporte notamment en tête des moyens de correction DRT (« Derotator » en langue anglaise) aptes à corriger les décalages fréquentiels des synthétiseurs de fréquence.

En amont des moyens de correction DRT, le signal est centré sur ladite fréquence prédéterminée (zéro dans le cas d'une architecture ZIF, ou bien différente de zéro) à un décalage fréquentiel Δf près.

A la sortie des moyens de correction DRT, ladite fréquence intermédiaire est supprimée à Δf près et le signal est dit alors pseudo bande de base, et est centré sur la fréquence Δf.

De tels moyens de correction (dérotation) sont classiques et connus en eux-mêmes. Ils peuvent être par exemple ceux décrits dans la demande de brevet européen n° 0 481 543.

Les moyens de correction DRT sont suivis d'une boucle de synchronisation BS, également classique et connue en soi, dont la fonction est de synchroniser le rythme des données reçues sur le rythme des données transmises.

La boucle de synchronisation BS est suivie d'un dispositif DIS selon l'invention, permettant d'estimer le décalage fréquentiel Δf et de corriger en conséquence la fréquence porteuse du signal incident reçu.

Le dispositif DIS est suivi d'un égaliseur EGL, de structure classique, lui-même suivi d'un étage de correction d'erreur effectuant les traitements classiques des corrections d'erreur bien connus de l'homme du métier, sous la dénomination anglosaxonne de FEC (« Forward Erreur Correction »). L'étage de correction d'erreur délivre ensuite un flux Fx qui sera décodé dans un bloc de décodage de source afin de restituer les données émises. Il est à noter que l'égaliseur EGL peut être intégré dans la boucle à verrouillage de phase présente dans le dispositif DIS.

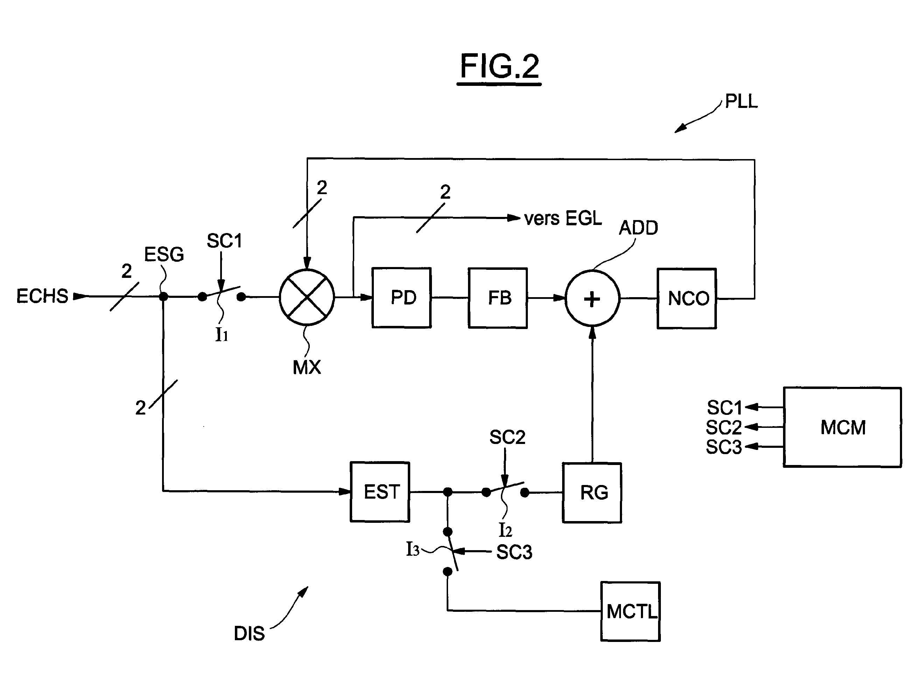

Sur la figure 2, on voit que le dispositif DIS comporte une entrée de signal ESG recevant les échantillons incidents ECHS des deux voies I et Q.

Un dispositif d'estimation de fréquence EST est relié à l'entrée de signal ESG.

Comme on le verra plus en détail ci-après, cet estimateur de fréquence EST va délivrer une première valeur d'estimation dudit décalage fréquentiel Δf, qui va être stockée dans un moyen de mémoire RG, tel qu'un registre.

Outre cet estimateur de fréquence, le dispositif DIS comporte une boucle de verrouillage de phase PLL comportant un mélangeur complexe MX relié à l'entrée de signal ESG par l'intermédiaire d'un interrupteur commandé par un signal SC1.

La boucle à verrouillage de phase PLL comporte également de façon classique un détecteur de phase PD suivi d'un filtre de boucle passe-bande FB.

Entre ce filtre de boucle FB et l'oscillateur commandé de boucle, qui est ici un oscillateur numérique commandé NCO, est disposé un additionneur ADD dont une première entrée est connectée à la sortie du filtre de boucle et dont l'autre entrée est connectée au registre RG.

La sortie de l'additionneur ADD est reliée à l'entrée de commande de l'oscillateur NCO.

La sortie de ce dernier est rebouclée sur l'autre entrée du mélangeur MX.

La sortie du mélangeur MX, lorsque la boucle de phase se sera verrouillée après avoir affiné l'estimation du décalage fréquentiel Δf, sera un signal sur les deux voies I et Q, centré sur la fréquence nulle. Ce signal est délivré à l'égaliseur EGL.

Par ailleurs, des moyens de commande MCM délivrent les signaux de commande SC1, SC2 et SC3, commandant respectivement les interrupteurs correspondants I1, I2, I3.

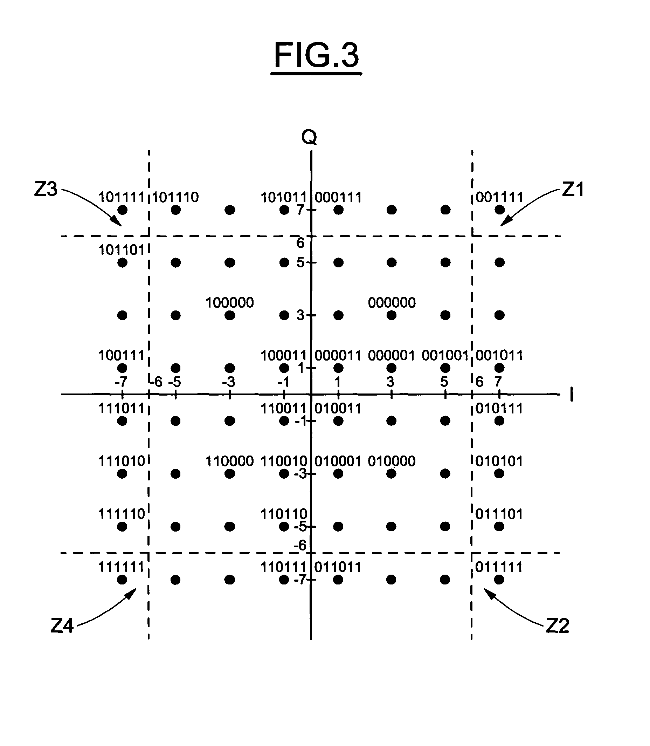

On va maintenant décrire en détail le fonctionnement du dispositif DIS, en se référant également aux figures 3, 4 et 5.

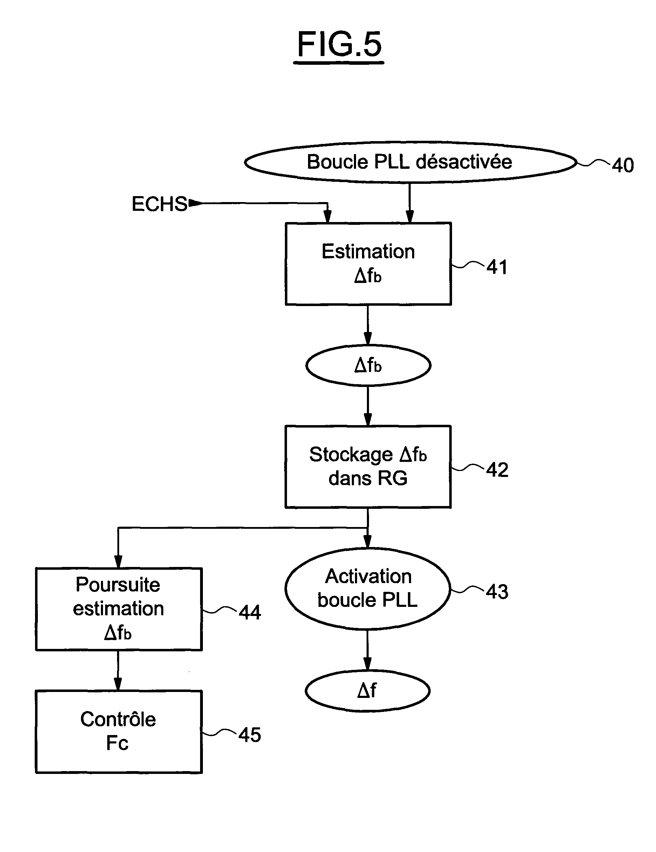

Pendant une première phase de réception des échantillons ECHS, la boucle PLL est désactivée (étape 40, figure 5), ce que l'on a symbolisé sur la figure 2 par l'interrupteur I1 ouvert.

Bien que différentes structures d'estimateur peuvent être utilisées, l'estimateur EST décrit ici à titre indicatif est semblable à un estimateur utilisé pour une modulation 4QAM ou QPSK et ce quelle que soit la taille de la modulation. Il estime (étape 41) le décalage fréquentiel Δf en calculant d'abord les phases des différents échantillons retenus, puis en calculant les dérivées temporelles de ces phases calculées (après suppression de la modulation). Ceci est effectué sur un nombre prédéterminé d'échantillons, par exemple sur une centaine de milliers d'échantillons. La moyenne des valeurs ainsi obtenues est proportionnelle à l'estimation du décalage fréquentielle et permet de fournir une première valeur d'estimation Δf_{b} de la valeur du décalage fréquentiel.

Une solution pour calculer la phase d'un nombre complexe consiste à implanter dans les moyens d'estimation un algorithme spécifique connu par l'homme du métier sous le nom CORDIC (« Coordinate Rotation Digital Computer »), publié dans la revue IRE Trans.Electrons.Compute.EC-8, pages 330-334 (J.Volder-1959).

Cela étant, en présence d'une modulation de type QAM par exemple, avec un nombre d'états élevés, par exemple 64, , la suppression de la modulation devient très complexe (l'opération de suppression de la modulation est aussi couramment appelée levée d'ambiguïté).

Aussi, on choisira avantageusement de ne prendre que des points « faciles » à traiter, c'est-à-dire, en l'espèce, des points situés dans des zones de coins de la constellation.

Plus précisément, la figure 3 illustre la constellation de points d'une modulation d'amplitude en quadrature carrée à 64 états, c'est-à-dire 6 bits par symbole (dite « modulation 64-QAM »). Dans cette constellation de points, à chacun des 64 symboles codés sur 6 bits, correspondent deux mots I et Q de trois bits ayant une valeur prédéterminée.

Les points de la constellation situés aux coins du carré, sont ceux pour lesquels I et Q valent (en l'absence de décalage fréquentiel) 7 en valeur absolue.

En conséquence, les zones de coins Z1-Z4 seront définies comme les zones pour lesquelles les valeurs I et Q des échantillons reçus sont (en l'absence de décalage fréquentiel) en valeur absolue supérieures à un seuil prédéterminé, en l'espèce 6.

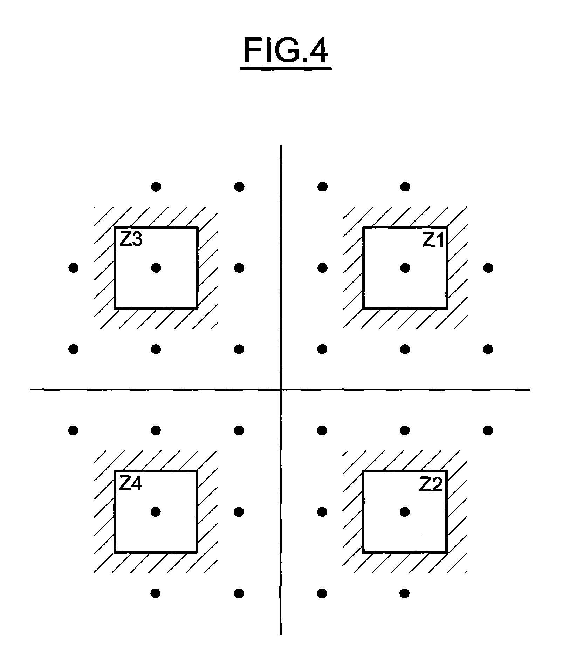

De même, la figure 4s illustre la constellation de points d'une modulation d'amplitude en quadrature non-carrée à 32 états, c'est-à-dire 5 bits par symbole (dite « modulation 32-QAM »). Dans cette constellation de points, à chacun des 32 symboles codés sur 5 bits, correspondent deux mots I et Q de trois bits ayant une valeur prédéterminée.

Le carré interne de la constellation correspond aux points de la constellation pour lesquels I et Q valent (en l'absence de décalage fréquentiel) 3 en valeur absolue.

En conséquence, les zones de coins Z1-Z4 seront définies comme les zones pour lesquelles les valeurs I et Q des échantillons reçus sont (en l'absence de décalage fréquentiel) en valeur absolue supérieures à un premier seuil prédéterminé, en l'espèce 2 et inférieures à un second seuil prédéterminé, en l'espèce 4.

Ainsi, pour chaque échantillon reçu, les moyens d'estimation EST ne retiennent et ne traitent que ceux situés dans les zones de coins Z1-Z4.

On se ramène ainsi en quelque sorte au traitement d'une modulation de type QPSK (c'est-à-dire une modulation 4-QAM) beaucoup moins complexe à traiter en ce qui concerne la suppression de la modulation.

En contrepartie, l'estimation de fréquence ainsi obtenue perd en précision, mais sera de toute façon affinée par la boucle à verrouillage de phase.

A cet égard, la plage fréquentielle d'accrochage de l'estimateur, c'est-à-dire la plage fréquentielle en dehors de laquelle on ne peut pas estimer le décalage fréquentiel, dépend de la vitesse d'émission des données, ainsi que des caractéristiques de l'algorithme d'estimation. L'homme du métier saura ajuster les caractéristiques de l'algorithme, de façon à obtenir une boucle d'accrochage de l'estimateur suffisamment grande, par exemple de l'ordre de quelques centaines de KHz. L'une des caractéristiques de l'algorithme sur laquelle on peut jouer pour régler la plage fréquentielle d'accrochage de l'estimateur, est le nombre d'échantillons non situés dans les zones de coins, que l'on tolère entre deux échantillons situés dans des zones de coins.

A titre indicatif, pour un nombre égal à quatre, on obtient une plage fréquentielle d'accrochage de l'ordre de quelques centaines de KHz pour des modulations ayant des vitesses de l'ordre de 5 Mbauds.

A l'issu de cette phase d'estimation 41 (figure 5), la première valeur d'estimation Δf_{b} est stockée dans le registre RG (interrupteur I2 fermé, étape 42, figure 5).

La boucle à verrouillage de phase PLL est alors activée (étape 43 ; interrupteur I1 fermé ; interrupteur I2 ouvert) et l'interrupteur I3 est ouvert.

La boucle à verrouillage de phase PLL est donc initialisée avec la valeur Δf_{b} issue du registre RG et va affiner l'estimation du décalage fréquentiel jusqu'à délivrer en sortie du mélangeur MX un signal centré sur la fréquence nulle. La plage fréquentielle d'accrochage de la boucle de décalage de phase est étroite. Plus précisément, elle est choisie inférieure, voire très inférieure à la plage d'accrochage fréquentielle de l'estimateur de fréquence EST, mais supérieure à l'erreur maximum d'estimation en sortie de l'estimateur EST. A titre indicatif, on choisira en particulier les caractéristiques du filtre de boucle FB de façon à avoir une plage fréquentielle d'accrochage de quelques KHz pour la boucle PLL.

Lors de l'activation de la boucle PLL (étape 43), les moyens d'estimation EST poursuivent avantageusement l'estimation du décalage fréquentiel (étape 44). Ces valeurs d'estimation son alors transmises à des moyens de contrôle MCTL (interrupteur I3 fermé), de façon à effectuer un contrôle de l'évolution de la fréquence porteuse Fc (étape 45). A cet égard, les moyens de contrôle vont vérifier que les différentes valeurs estimées du décalage fréquentiel ne varient pas trop. Plus précisément, une façon de vérifier ceux-ci consiste à calculer la variance des valeurs estimées et à comparer cette variance à un seuil prédéterminé. Selon un mode de mise en oeuvre de l'invention, si cette variance est supérieure au seuil prédéterminé, le système pourra être réinitialisé (retour à l'étape 40).

## Revendications

1. Procédé de traitement du décalage fréquentiel de la fréquence porteuse d'un signal incident modulé avec une modulation monoporteuse continue en quadrature, **caractérisé par le fait qu'**on effectue une première estimation dudit décalage avec un estimateur de fréquence (EST) de façon à obtenir une première valeur d'estimation puis on affine l'estimation dudit décalage fréquentiel et on corrige en conséquence la fréquence porteuse, avec une boucle à verrouillage de phase (PLL) initialisée avec ladite première valeur d'estimation et dont la plage fréquentielle d'accrochage est inférieure à la plage fréquentielle d'accrochage de l'estimateur de fréquence.

2. Procédé selon la revendication 1, **caractérisé par le fait que** l'oscillateur de boucle (NCO) de la boucle à verrouillage de phase est commandé par la sortie du filtre de boucle augmentée par ladite première valeur d'estimation

3. Procédé selon la revendication 1 ou 2, **caractérisé par le fait que** le signal reçu par l'estimateur de fréquence (EST) comporte des échantillons appartenant à une constellation de points comportant un carré interne ou externe, et **par le fait qu'**on effectue ladite première estimation en utilisant uniquement des échantillons reçus situés dans les zones de coins du carré.

4. Procédé selon l'une des revendications précédentes, **caractérisé par le fait qu'**on effectue ladite première estimation sur un nombre prédéterminé d'échantillons du signal reçu par l'estimateur de fréquence.

5. Procédé selon l'une des revendications précédentes, **caractérisé par le fait qu'**après l'activation de la boucle à verrouillage (PLL) de phase, on poursuit l'estimation dudit décalage fréquentiel avec l'estimateur de fréquence, et on utilise cette nouvelle estimation pour contrôler (MCTL) l'évolution de la valeur de la fréquence porteuse.

6. Dispositif de traitement du décalage fréquentiel de la fréquence porteuse d'un signal incident modulé avec une modulation monoporteuse continue en quadrature, **caractérisé par le fait qu'**il comprend une entrée de signal (ESG), un estimateur de fréquence (EST) connecté à ladite entrée apte à délivrer une première valeur d'estimation dudit décalage fréquentiel, une boucle à verrouillage de phase (PLL) connectée à ladite entrée et dont la plage fréquentielle d'accrochage est inférieure à la plage fréquentielle d'accrochage de l'estimateur de fréquence, et **par le fait qu'**il comporte des moyens de commande (MCM) aptes à n'activer la boucle à verrouillage de phase qu'à la délivrance de ladite première valeur d'estimation, et des moyens d'initialisation aptes à initialiser la boucle à verrouillage de phase avec ladite première valeur d'estimation.

7. Dispositif selon la revendication 6, **caractérisé par le fait que** les moyens d'initialisation comportent un moyen de mémoire (RG) apte à stocker ladite première valeur d'estimation et un additionneur (ADD) possédant une première entrée connectée à la sortie du filtre de boucle, une deuxième entrée connectée audit moyen de mémoire et une sortie connectée à l'entrée de commande de l'oscillateur de boucle.

8. Dispositif selon la revendication 6 ou 7, **caractérisé par le fait que** le signal reçu par l'estimateur de fréquence (EST) comporte des échantillons appartenant à une constellation de points comportant un carré interne ou externe, et **par le fait que** ledit estimateur de fréquence effectue ladite première estimation en utilisant uniquement des échantillons reçus situés dans les zones de coins du carré.

9. Dispositif selon l'une des revendications 6 à 8, **caractérisé par le fait que** ledit estimateur (EST) effectue ladite première estimation sur un nombre prédéterminé d'échantillons du signal reçu par l'estimateur de fréquence.

10. Dispositif selon l'une des revendications 6 à 9, **caractérisé par le fait que** les moyens de commande (MCM) déconnectent l'estimateur de fréquence de la boucle à verrouillage de phase après l'activation de la boucle à verrouillage de phase, **par le fait que** l'estimateur poursuit l'estimation dudit décalage fréquentiel, et **par le fait que** le dispositif comporte en outre des moyens de contrôle (MCTL) connectés à la sortie de l'estimateur et aptes à utiliser cette nouvelle estimation pour contrôler l'évolution de la valeur de la fréquence porteuse.

11. Dispositif selon l'une des revendications 6 à 10, **caractérisé par le fait qu'**il est réalisé de façon intégrée.

12. Récepteur de signaux modulés avec une modulation monoporteuse continue en quadrature, **caractérisé par le fait qu'**il comporte un dispositif selon l'une des revendications 6 à 11.
